# EUROPÄISCHE PATENTSCHRIFT

(11) **EP 3 028 021 B1**
(45) Veröffentlichungstag und Bekanntmachung des Hinweises auf die Patenterteilung: **12.02.2020**
(21) Anmeldenummer: 14744323.8
(22) Anmeldetag: 25.07.2014
(51) Int. Cl.: G01J 5/34

(54) **VERFAHREN ZUM HERSTELLEN EINES MIKROSYSTEMS MIT PIXEL**
METHOD FOR PRODUCING A MICROSYSTEM HAVING PIXELS
PROCÉDÉ DE PRODUCTION D'UN MICROSYSTÈME À PIXELS

(30) Priorität: 01.08.2013 DE 102013108280
(43) Veröffentlichungstag der Anmeldung: 08.06.2016
(73) Patentinhaber: Pyreos Ltd., Edinburgh EH9 3JF (GB)
(72) Erfinder: GIEBELER, Carsten, Edinburgh EH32 0PE (GB); CONWAY, Neil, Dunfermline, Fife KY12 8YL (GB)
(74) Vertreter: Mewburn Ellis LLP
(86) Internationale Anmeldenummer: PCT/EP2014/066084
(87) Internationale Veröffentlichungsnummer: WO 2015/014754

(56) Entgegenhaltungen:
- DE-A1- 10 103 529
- DE-A1- 19 525 071
- US-A1- 2012 161 002
- US-A1- 2013 023 063

## Beschreibung

Die Erfindung betrifft ein Verfahren zum Herstellen eines Mikrosystems mit Pixel.

Dünnschichten aus Bleizirkonattitanat (PZT) sind aufgrund ihrer vorteilhaften physikalischen Eigenschaften, wie beispielsweise einer hohen elektromechanischen Kopplung, einer hohen Dielektrizitätszahl oder einem hohen pyroelektrischen Koeffizienten, in der Mikrosystemtechnik weit verbreitet. Ein Mikrosystem weist herkömmlich ein Substrat als einen Träger für die Dünnschicht auf, wobei das Substrat eine Membran aufweist, die von einem Siliziumrahmen aufgespannt ist. Es ist bekannt, die Bleizirkonattitanat-Dünnschicht mit einem Abscheideverfahren, insbesondere einem Sputter-Prozess, auf das Substrat aufzubringen. Eine rasterartige Anordnung von Pixel aus der Dünnschicht wird herkömmlich mit einem fotolithographischen Ätzverfahren erreicht. Die Pixel sind mit Elektroden elektronisch verschaltet, die beispielsweise aus Platin oder einer Chrom-Nickel-Legierung hergestellt sind.

Patentschrift US 2013/0023036 A1 offenbart in Figur 9C ein typisches Dünnfilmpixelsystem, das als pyroelektrischer Infrarotsensor mit Goldpixelelektroden verwendet wird, die auf einer Oxid-Doppelschichtmembran ausgebildet sind.

Es ist erforderlich, dass die Membran eine kleine thermische Masse und eine geringe thermische Leitfähigkeit hat, damit thermisches Übersprechen zwischen den Pixel gering ist. Dies wird dadurch erreicht, dass die Membran aus einem schlecht wärmeleitfähigen Material, beispielsweise Siliziumoxid, und möglichst dünn ausgebildet ist. Typischerweise beträgt die Dicke der Membran 1 µm bei einer Rahmenhöhe von 400 µm. Mit Hilfe eines reaktiven Ionentiefenätzverfahrens ist es möglich, die Rückseite des Substrats derart stark anisotrop zu strukturieren, dass Kavitäten ausgebildet werden können. Die Kavitäten erstrecken sich unmittelbar bis zur Membran, so dass diese an ihrer den Pixel abgewandten Seite durch die Kavitäten freigelegt ist. Erstrebenswert ist es die Membran möglichst dünn und mit einer ausreichend hohen Festigkeit herzustellen, damit die Pixel aufgrund geringen Übersprechens eine hohe Funktionalität haben.

Um die Membran zu stabilisieren ist es bekannt eine zusätzliche Si₃N₄-Schicht auf dem Substrat vorzusehen. Die zusätzliche Si₃N₄-Schicht hat jedoch den Nachteil, dass ihre Wärmeleitfähigkeit derart groß ist, dass mit ihr das nachteilige Übersprechen zwischen den einzelnen Pixel erhöht ist. Außerdem erfordert das Herstellen der zusätzlichen Si₃N₄-Schicht einen weiteren Fertigungsschritt, wodurch höhere Herstellungskosten einhergehen.

Aufgabe der Erfindung ist es ein Verfahren zur Herstellung eines Mikrosystems mit Pixel zu schaffen, wobei die Pixel eine hohe Funktionalität haben und das Mikrosystem eine hohe mechanische Stabilität hat sowie die Herstellungskosten gering sind.

Die Aufgabe wird gelöst mit den Merkmalen des unabhängigen Patentanspruchs. Bevorzugte Ausgestaltungen dazu sind in den weiteren Patentansprüchen angegeben.

Das erfindungsgemäße Verfahren zum Herstellen des Mikrosystems mit den Pixel weist die Schritte auf: Bereitstellen eines Siliziumwafers; Herstellen einer thermischen Siliziumoxidschicht an der Oberfläche des Siliziumwafers als eine Basisschicht mit einer Dicke zwischen 200 nm und 1000 nm durch Oxidation des Siliziumwafers; Herstellen einer Siliziumoxiddünnschicht unmittelbar auf der Basisschicht als eine Trägerschicht mit einer Dicke von 100 nm bis 700 nm durch ein thermisches Abscheideverfahren; Herstellen einer Platinschicht unmittelbar auf der Trägerschicht mit einem thermischen Abscheideverfahren mit einer Dicke von 40 nm bis 200 nm, wodurch ein Zwischenprodukt aufweisend den Siliziumwafer, die Basisschicht, die Trägerschicht und die Platinschicht hergestellt wird; Abkühlen des Zwischenprodukts auf Raumtemperatur; pixelartige Strukturierung der Platinschicht durch Abtragen von überflüssigen Bereichen der Platinschicht, wodurch auf der Trägerschicht von den verbleibenden Bereichen der Platinschicht pixelförmig Bodenelektroden der Pixel ausgebildet werden; Materialabtragung an der der Basisschicht abgewandten Seite des Siliziumwafers, so dass ein Rahmen verbleibt und von dem Rahmen eine Membran gebildet von der Basisschicht und der Trägerschicht aufgespannt wird; Fertigstellen des Mikrosystems.

Bei der Herstellung des Mikrosystems mit dem erfindungsgemäßen Verfahren ergibt sich das Zwischenprodukt als ein Schichtverbund, der die Basisschicht als die thermische Siliziumoxidschicht mit der Dicke von 200 nm bis 1000 nm, die Trägerschicht als die Siliziumoxiddünnschicht mit der Dicke von 100 nm bis 700 nm und die Platinschicht mit der Dicke von 40 nm bis 200 nm aufweist, wobei die Schichten direkt aneinander liegen und miteinander fest verbunden sind. Nach dem Abkühlen des Zwischenprodukts stellt sich in den Schichten ein entsprechender Spannungszustand ein, der dadurch charakterisiert ist, dass sowohl in der Basisschicht als auch in der Trägerschicht Druckspannungen und in der Platinschicht Zugspannungen vorliegen. Die Druckspannungen in der Trägerschicht sind etwa um fünf- bis zehnmal kleiner als in der Basisschicht und die Zugspannungen in der Platinschicht liegen etwa bei 5 bis 20 MPa. Ferner ist zu beobachten, dass nach der Strukturierung der Platinschicht zu den Platinschichtpixel als die Bodenelektroden in diesen Zugspannungen vorliegen, deren Werte verglichen zu den Zugspannungen in der Platinschicht vor der Strukturierung im Wesentlichen unverändert sind. An den Stellen der Trägerschicht und der Basisschicht, an denen die Platinschichtpixel angeordnet sind, ergibt sich eine Überkompensation der Druckspannungen in der Basisschicht und der Trägerschicht von den Zugspannungen in den Platinschichtpixel derart, dass Zugspannungen und keine Druckspannungen vorliegen. Somit dienen die Platinschichtpixel mit Ihren Zugspannungen zur lokalen Kompensation der Druckspannungen der Basisschicht und der Trägerschicht. Überaschenderweise stellt sich die lokale Kompensation der Druckspannungen der Basisschicht und der Trägerschicht durch die Platinschichtpixel ein, obwohl die Platinschicht nach der Strukturierung der Platinschichtpixel nicht mehr durchgängig auf der Oberfläche vorhanden ist, sondern nur noch in Form der Platinschichtpixel. Die Zugspannungen, die aufgrund der Kompensationswirkung der Platinschichtpixel auf der Trägerschicht und der Basisschicht wirken haben Werte bis etwa 50 MPa.

Mit Hilfe der erfindungsgemäß in der Membran generierten Spannungszuständen hat die Membran eine hohe Festigkeit, so dass die Membran etwa beim Herstellen des Mikrosystems nicht bricht, obwohl die Membran erfindungsgemäß mit der derart geringen Dicke gebildet ist. Ferner sind die Spannungsgradienten in der Basisschicht und der Trägerschicht derart moderat, dass die Basisschicht und die Trägerschicht eine hohe mechanische Stabilität haben. Außerdem haben die Trägerschicht und die Basisschicht eine derart niedrige Wärmeleitfähigkeit, dass das Übersprechen zwischen den Pixel gering ist. Dadurch hat das Mikrosystem ein vorteilhaft hohes Signal-Rausch-Verhältnis insbesondere für Frequenzen, die kleiner als die thermische Grenzfrequenz sind. Das erfindungsgemäße Verfahren zum Herstellen des Mikrosystems weist Prozessschritte zum Herstellen der Basisschicht und der Trägerschicht auf, wodurch zusätzliche Prozessschritte etwa zum Herstellen einer mechanisch stabilisierenden Si₃N₄-Schicht nicht notwendig sind. Dadurch sind die Herstellungskosten des erfindungsgemäßen Mikrosystems geringer als für bekannte Mikrosysteme.

Beforzugtermaßen wird die Platinschicht bei 300 °C bis 550°C gesputtert. Ferner weist das Verfahren bevorzugt den Schritt auf: Herstellen einer Bleizirkonattitanatschicht unmittelbar auf der Platinschichtschicht mit einem thermischen Abscheideverfahren und einer Dicke von 0,2 bis 5 µm, wodurch das Zwischenprodukt die Bleizirkonattitanatschicht aufweist. Hierbei ist es bevorzugt, dass bei der pixelartigen Strukturierung der Platinschicht gleichzeitig die Bleizirkonattitanatschicht durch Abtragen von überflüssigen Bereichen der Bleizirkonattitanatschicht strukturiert wird, wodurch auf den Bodenelektroden von den verbleibenden Bereichen der Bleizirkonattitanatschicht Bleizirkonattitanatpixel der Pixelen ausgebildet werden.

Das Verfahren weist ferner bevorzugt den Schritt auf: Herstellen einer semitransparenten, elektrisch leitenden Elektrodenschicht unmittelbar auf der Bleizirkonattitanatschicht mit einem thermischen Abscheideverfahren, wodurch das Zwischenprodukt die Elektrodenschicht aufweist. Hierbei ist es bevorzugt, dass die Elektrodenschicht aus Platin oder einer Nickel-Eisen-Verbindung oder einer Nickel-Chrom-Verbindung ist. Bei der pixelartigen Strukturierung der Platinschicht und der Bleizirkonattitanatschicht werden bevorzugt gleichzeitig die Elektrodenschicht durch Abtragen von überflüssigen Bereichen der zweiten Platinschicht strukturiert wird, wodurch auf den Bleizirkonattitanatpixel von den verbleibenden Bereichen der zweiten Platinschicht Kopfelektroden der Pixel ausgebildet werden.

Außerdem ist es bevorzugt, dass das thermisches Abscheideverfahren ein Sputter-Verfahren ist.

Im Folgenden wird ein bevorzugtes Ausführungsbeispiel eines mit dem erfindungsgemäßen Verfahren hergestellten Mikrosystems anhand der beigefügten schematischen Zeichnungen erläutert. Es zeigen:
Figur 1 eine Querschnittsdarstellung des Ausführungsbeispiels des mit dem erfindungsgemäßen Verfahren hergestellten Mikrosystem und
Figur 2 eine Draufsicht des Ausführungsbeispiels aus Figur 1.

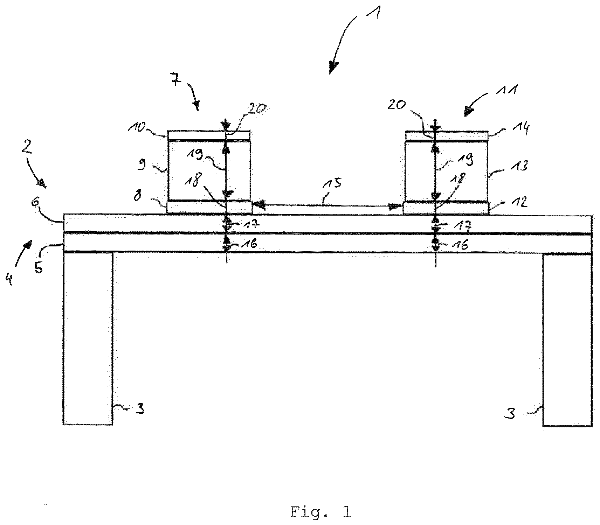

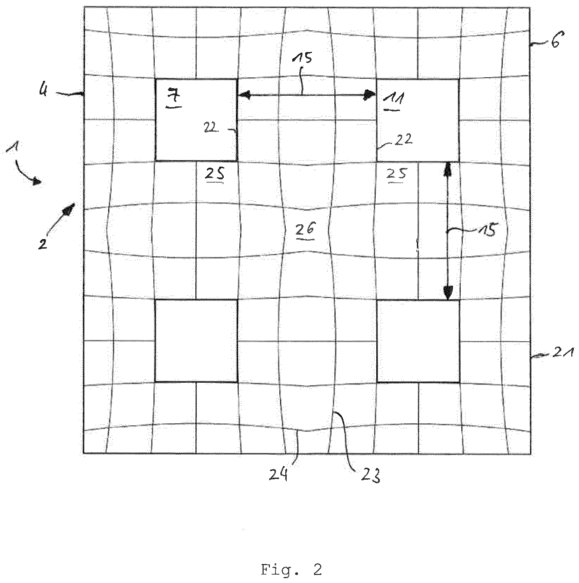

Wie es aus Figuren 1 und 2 ersichtlich ist weist ein als ein Mikrosystem hergestellter Infrarotlichtsensorchip 1 ein Substrat 2 auf, das seinerseits einen Rahmen 3 und eine Membran 4 aufweist. Auf dem Rahmen 3 ist die Membran 4 angebracht, so dass von dem Rahmen 3 die Membran 4 abgestützt und aufgespannt ist. Die Membran 4 weist eine Basisschicht 5, die eine thermische Siliziumoxidschicht ist, und eine Trägerschicht 6 auf, die eine Siliziumoxiddünnschicht ist.

Auf der Trägerschicht 6 sind ein erster Infrarotlichtsensor 7 mit einer ersten Bodenelektrode 8 aus Platin, einem ersten Bleizirkonattitanatpixel 9 mit einem hohen Anteil an Zirkon und einer ersten Kopfelektrode 10 aus Platin sowie ein zweiter Infrarotlichtsensor 11 mit einer zweiten Bodenelektrode 8 aus Platin, einem zweiten Bleizirkonattitanatpixel 9 mit einem hohen Anteil an Zirkon und einer zweiten Kopfelektrode 10 aus Platin angeordnet. Die Bleizirkonattitanatpixel 9, 13 sind jeweils zwischen ihren Bodenelkroden 8, 12 und ihren Kopfelektroden 10, 14 angeordnet, wobei die Bodenelektroden 8, 12 direkt auf der Trägerschicht 6 angeordnet sind.

Die Kopfelektroden 10, 14 sind semitransparent ausgebildet, so dass Infrarotlicht von außen auf die Bleizirkonattitanatpixel 9, 13 treffen kann. Der Abstand 15 zwischen den Infrarotlichtsensoren 7, 11 ist derart groß gewählt, dass das Übersprechen zwischen den Infrarotlichtsensoren 7, 11 innerhalb eines noch zulässigen Ausmaßes ist. Die Basisschicht 5 hat eine Dicke 16 zwischen 200 nm und 1000 nm und die Trägerschicht 6 hat eine Dicke 17 von 100 nm bis 700 nm, wohingegen die Bodenelektroden 8, 12 eine Dicke 18 von 40 nm bis 200 nm haben. Die Bleizirkonattitanatpixel 9, 13 haben eine Dicke 19 von wenigen Mikrometern, insbesondere von 2 bis 5 µm. Die Kopfelektroden 10, 14 haben eine Dicke 20 von 3 bis 200 nm.

Zum Herstellen des Infrarotlichtsensorchips sind folgende Schritte durchzuführen: Die thermische Siliziumoxidschicht wird an der Oberfläche eines Siliziumwafers als die Basisschicht 5 mit der Dicke 16 durch Oxidation des Siliziumwafers hergestellt. Ferner wird die Siliziumoxiddünnschicht unmittelbar auf der Basisschicht 5 als die Trägerschicht 6 mit der Dicke 17 durch ein thermisches Abscheideverfahren hergestellt. Eine Platinschicht wird danach unmittelbar auf die Trägerschicht 17 mit der Dicke 18 bei 300 °C bis 550°C gesputtert. Anschließend wird eine Bleizirkonattitanatschicht unmittelbar auf die Platinschichtschicht mit einem thermischen Abscheideverfahren und der Dicke 19 aufgebracht. Unmittelbar auf die Bleizirkonattitanatschicht wird anschließend eine semitransparente, elektrisch leitende Elektrodenschicht aus Platin oder einer Nickel-Eisen-Verbindung oder einer Nickel-Chrom-Verbindung mit einem thermischen Abscheideverfahren und der Dicke 20 aufgebracht.

Anschließend wird der Siliziumwafer mit der Basisschicht 5, der Trägerschicht 6, der Platinschicht, der Bleizirkonattitanatschicht und der Elektrodenschicht auf Raumtemperatur abgekühlt. Alternativ ist denkbar die Elektrodenschicht erst nach der Abkühlung auf die Bleizirkonattitanatschicht aufzubringen. Nach dem Abkühlen stellen sich sowohl in der Basisschicht 5 als auch in der Trägerschicht 6 Druckspannungen und in der Platinschicht Zugspannungen ein. Die Druckspannungen in der Trägerschicht 6 sind etwa um fünf- bis zehnmal kleiner als in der Basisschicht 5 und die Zugspannungen in der Platinschicht liegen etwa bei 5 bis 20 MPa.

Es wird ferner eine pixelartige Strukturierung vorgenommen, wobei überflüssige Bereiche der Platinschicht, der Bleizirkonattitanatschicht und der Elektrodenschicht abgetragen werden, so dass die Infrarotlichtsensoren 7, 11 im Abstand 15 zueinander herausgearbeitet werden. Schließlich wird durch Materialabtragung an der der Basisschicht abgewandten Seite des Siliziumwafers eine Aussparung hergestellt, so dass vom Siliziumwafer der Rahmen 3 verbleibt, von dem die Membran 4 gebildet von der Basisschicht 5 und der Trägerschicht 6 aufgespannt wird.

Nach der pixelartigen Strukturierung liegen in den Bodenelektroden 8, 12 Zugspannungen vor, deren Werte verglichen zu den Zugspannungen in der Platinschicht vor der Strukturierung im Wesentlichen unverändert sind. An den Stellen der Trägerschicht 6 und der Basisschicht 5, an denen die Bodenelektroden 8, 12 angeordnet sind, ergibt sich eine Überkompensation der Druckspannungen in der Basisschicht 5 und der Trägerschicht 6 von den Zugspannungen in den Bodenelektroden 8, 12 derart, dass Zugspannungen und keine Druckspannungen vorliegen. Somit dienen die Bodenelektroden 60 12 mit ihren Zugspannungen zur lokalen Kompensation der Druckspannungen der Basisschicht 5 und der Trägerschicht 6. Es stellt sich die lokale Kompensation der Druckspannungen der Basisschicht 5 und der Trägerschicht 6 durch die Bodenelektroden 8, 12 ein, obwohl die Platinschicht nach der Strukturierung des Infrarotlichtsensors nicht mehr durchgängig auf der Oberfläche der Trägerschicht 6 vorhanden ist. Die Zugspannungen, die aufgrund der Kompensationswirkung der Bodenelektroden 8, 12 auf der Trägerschicht 6 und der Basisschicht 5 wirken haben Werte bis etwa 50 MPa.

In Figur 2 ist die Kompensationswirkung der Bodenelektroden 8, 12 mit ersten und zweiten Rasterlinien 23, 24 angedeutet. Wäre die Kompensationswirkung der Bodenelektroden 8, 12 nicht vorhanden, würden die Raserlinien 23, 24 ein gleichmäßiges Raster bilden, wobei die ersten Rasterlinien 23 in Figur 2 senkrecht verlaufen und zu den senkrechten Abschnitten des Rands 21 der Trägerschicht 6 parallel und die zweiten Rasterlinien 24 in Figur 2 waagrecht verlaufen und zu den waagerechten Abschnitten des Rands 21 der Trägerschicht 6 parallel verlaufen würden.

Aufgrund der Überlagerung der Zugspannungen in den Bodenelektroden 8, 12 mit den Druckspannungen in der Trägerschicht 6 und der Basisschicht 5 ergibt sich eine Verzerrung der Rasterlinien 23, 24, so dass im Bereich der Ränder 22 der Bodenelektroden 8, 12 in der Trägerschicht 6 und der Basisschicht 5 Zonen 25 mit hoher Zugspannung und in der Mitte der Membran 4 in der Trägerschicht 6 und der Basisschicht 5 Zonen 25 mit niedriger Zugspannung ausbilden.

Obwohl die Basisschicht 5 und die Trägerschicht derart dünn ausgebildet sind, bleibt die Membran 4 während des Abkühlens auf die Raumtemperatur unbeschädigt. Dies wird durch die Kompensationswirkung der Bodenelektroden 8, 12 erzielt. Die Kompensationswirkung geht hauptsächlich von den Bodenelektroden 8, 12 aus. Einen Beitrag zur Kompensationswirkung leisten analog die Bleizirkonattitanatpixel 9, 13 und die Kopfelektroden 10, 14. Der Beitrag der Kopfelektroden 10, 14 ist klein verglichen mit dem Beitrag der Bleizirkonattitanatpixel 9, 13, da die Kopfelektroden 10, 14 aufgrund ihrer Semitransparenz sehr dünn ausgeführt sind. Ferner sind die Spannungsgradienten in der Membran 4 derart moderat, dass die Membran 4 auch nach der Abkühlung eine hohe mechanische Stabilität hat. Das Siliziumoxid, aus dem die Trägerschicht 6 und die Basisschicht 5 sind, hat vorteilhaft eine derart niedrige Wärmeleitfähigkeit, dass das Übersprechen zwischen den einzelnen Infrarotlichtsensoren 7, 11 gering ist. Dadurch hat Infrarotlichtsensorchip 1 ein vorteilhaft hohes Signal-Rasch-Verhältnis insbesondere für Frequenzen, die kleiner als die thermische Grenzfrequenz sind.

### Bezugszeichenliste

- 1: Pixelchip
- 2: Substrat
- 3: Rahmen
- 4: Membran
- 5: Basisschicht
- 6: Trägerschicht
- 7: erstes Pixel
- 8: erste Bodenelektrode
- 9: erste Bleizirkonattitanatpixel
- 10: erste Kopfelektrode
- 11: zweites Pixel
- 12: zweite Bodenelektrode
- 13: zweite Bleizirkonattitanatpixel
- 14: zweite Kopfelektrode
- 15: Abstand zwischen den Pixel
- 16: Dicke der Basisschicht
- 17: Dicke der Trägerschicht
- 18: Dicke der Bodenelektrode
- 19: Dicke der Bleizirkonattitanatpixel
- 20: Dicke der Kopfelektrode
- 21: Rand der Trägerschicht
- 22: Rand der Bodenelektrode
- 23: erste Rasterlinie
- 24: zweite Rasterlinie
- 25: Zone mit hoher Zugspannung
- 26: Zone mit niedriger Zugspannung

## Patentansprüche

1. Verfahren zum Herstellen eines Mikrosystems (1) mit Pixel, aufweisend die Schritte:
- Bereitstellen eines Siliziumwafers;
- Herstellen einer thermischen Siliziumoxidschicht an der Oberfläche des Siliziumwafers als eine Basisschicht (5) mit einer Dicke zwischen 200 nm und 1000 nm durch Oxidation des Siliziumwafers;
- Herstellen einer Siliziumoxiddünnschicht unmittelbar auf der Basisschicht (5) als eine Trägerschicht (6) mit einer Dicke von 100 nm bis 700 nm durch ein thermisches Abscheideverfahren;
- Herstellen einer Platinschicht unmittelbar auf der Trägerschicht (6) mit einem thermischen Abscheideverfahren mit einer Dicke von 40 nm bis 200 nm, wodurch ein Zwischenprodukt aufweisend den Siliziumwafer, die Basisschicht (5), die Trägerschicht (6) und die Platinschicht hergestellt wird;
- Abkühlen des Zwischenprodukts auf Raumtemperatur;
- pixelartige Strukturierung der Platinschicht durch Abtragen von überflüssigen Bereichen der Platinschicht, wodurch auf der Trägerschicht (6) von den verbleibenden Bereichen der Platinschicht pixelförmig Bodenelektroden (8, 12) der Pixel (7, 8) ausgebildet werden;
- Materialabtragung an der der Basisschicht (5) abgewandten Seite des Siliziumwafers, so dass ein Rahmen (3) verbleibt und von dem Rahmen (3) eine Membran (4) gebildet von der Basisschicht (5) und der Trägerschicht (6) aufgespannt wird;
- Fertigstellen des Mikrosystems (1).

2. Vefahren gemäß Anspruch 1, wobei die Platinschicht bei 300 °C bis 550°C gesputtert wird.

3. Vefahren gemäß Anspruch 1 oder 2, wobei das Verfahren den Schritt aufweist: Herstellen einer Bleizirkonattitanatschicht unmittelbar auf der Platinschichtschicht mit einem thermischen Abscheideverfahren und einer Dicke von 0,2 bis 5 µm, wodurch das Zwischenprodukt die Bleizirkonattitanatschicht aufweist.

4. Verfahren gemäß Anspruch 3, wobei bei der pixelartigen Strukturierung der Platinschicht gleichzeitig die Bleizirkonattitanatschicht durch Abtragen von überflüssigen Bereichen der Bleizirkonattitanatschicht strukturiert wird, wodurch auf den Bodenelektroden (8, 12) von den verbleibenden Bereichen der Bleizirkonattitanatschicht Bleizirkonattitanatpixel (9, 13) der Pixelen (7, 11) ausgebildet werden.

5. Verfahren gemäß einem der Ansprüche 3 bis 4, wobei das Verfahren den Schritt aufweist: Herstellen einer semitransparenten, elektrisch leitenden Elektrodenschicht unmittelbar auf der Bleizirkonattitanatschicht mit einem thermischen Abscheideverfahren, wodurch das Zwischenprodukt die Elektrodenschicht aufweist.

6. Verfahren gemäß Anspruch 5, wobei die Elektrodenschicht aus Platin oder einer Nickel-Eisen-Verbindung oder einer Nickel-Chrom-Verbindung ist.

7. Verfahren gemäß Anspruch 6, wobei bei der pixelartigen Strukturierung der Platinschicht und der Bleizirkonattitanatschicht gleichzeitig die Elektrodenschicht durch Abtragen von überflüssigen Bereichen der zweiten Platinschicht strukturiert wird, wodurch auf den Bleizirkonattitanatpixel (9, 13) von den verbleibenden Bereichen der zweiten Platinschicht Kopfelektroden (10, 14) der Pixel (7, 11) ausgebildet werden.

8. Verfahren gemäß einem der Ansprüche 1 bis 7, wobei das thermische Abscheideverfahren ein Sputter-Verfahren ist.

## Claims

1. Method for producing a microsystem (1) with pixels, having the steps:
- providing a silicon wafer;
- producing a thermal silicon oxide layer on the surface of the silicon wafer as a base layer (5) with a thickness between 200 nm and 1000 nm by oxidation of the silicon wafer;
- producing a silicon oxide thin layer directly on the base layer (5) as a carrier layer (6) with a thickness of 100 nm to 700 nm by a thermal deposition method;
- producing a platinum layer directly on the carrier layer (6) with a thermal deposition method with a thickness of 40 nm to 200 nm, through which an intermediate product having the silicon wafer, the base layer (5), the carrier layer (6) and the platinum layer is produced;
- cooling of the intermediate product to room temperature;
- pixel-type structuring of the platinum layer by removing superfluous areas of the platinum layer, through which bottom electrodes (8, 12) of the pixels (7, 8) are formed pixel-shaped on the carrier layer by the remaining areas of the platinum layer;
- removing material on the side of the silicon wafer facing away from the base layer (5), so that a frame (3) remains and a membrane (4) formed by the base layer (5) and the carrier layer (6) is tensioned by the frame (3);
- producing the microsystem (1).

2. Method according to claim 1, in which the platinum layer is sputtered at 300° C to 550° C.

3. Method according to claim 1 or 2, in which the method has the step: producing a lead zirconate titanate layer directly on the platinum layer with a thermal deposition method and a thickness of 0.2 to 5 µm, through which the intermediate product has the lead zirconate titanate layer.

4. Method according to claim 3, in which with the pixel-type structuring of the platinum layer at the same time the lead zirconate titanate layer is structured by removing superfluous areas of the lead zirconate titanate layer, through which lead zirconate titanate pixels (9, 13) of the pixels (7, 11) are formed on the bottom electrodes (8, 12) by the remaining areas of the lead zirconate titanate layer.

5. Method according to one of claims 3 to 4, in which the method has the step: producing a semitransparent, electrically conductive electrode layer directly on the lead zirconate titanate layer with a thermal deposition method, through which the intermediate product has the electrode layer.

6. Method according to claim 5, in which the electrode layer is made of platinum or a nickel-iron compound or a nickel-chrome compound.

7. Method according to claim 6, in which with the pixel-type structuring of the platinum layer and the lead zirconate titanate layer at the same time the electrode layer is structured by removing superfluous areas of the second platinum layer, through which head electrodes (10, 14) of the pixels (7, 11) are formed on the lead zirconate titanate pixels (9, 13) by the remaining areas of the second platinum layer.

8. Method according to one of claims 1 to 7, in which the thermal deposition method is a sputtering method.

## Revendications

1. Procédé de fabrication d'un système de micro (1) avec des pixels, comprenant les étapes suivantes :
- mise à disposition d'une tranche de silicium ;
- fabrication d'une couche d'oxyde de silicium thermique sur la surface de la tranche de silicium en tant que couche de base (5) avec une épaisseur entre 200 nm et 1000 nm par oxydation de la tranche de silicium ;
- fabrication d'une couche mince d'oxyde de silicium directement sur la couche de base (5) en tant que couche de support (6) avec une épaisseur de 100 nm à 700 nm par un procédé de dépôt thermique ;
- fabrication d'une couche de platine directement sur la couche de support (6) à l'aide d'un procédé de dépôt thermique avec une épaisseur de 40 nm à 200 nm, ce qui permet d'obtenir un produit intermédiaire comprenant la tranche de silicium, la couche de base (5), la couche de support (6) et la couche de platine ;
- refroidissement du produit intermédiaire à la température ambiante ;
- structuration de type pixels de la couche de platine par enlèvement de zones superflues de la couche de platine, ce qui permet de former, sur la couche de support (6), à l'aide des zones restantes de la couche de platine, des électrodes de fond (8, 12), en forme de pixels, des pixels (7, 8) ;
- enlèvement de matière sur le côté de tranche de silicium opposé à la couche de base (5), de façon à ce qu'un cadre (3) subsiste et à ce que, grâce au cadre (3), une membrane (4), constituée de la couche de base (5) et de la couche de support (6), soit tendue ;
- finition du système de micro (1).

2. Procédé selon la revendication 1, la couche de platine étant pulvérisée entre 300 °C et 550 °C.

3. Procédé selon la revendication 1 ou 2, le procédé comprenant l'étape suivante : fabrication d'une couche de zirconate-titanate de plomb directement sur la couche de platine à l'aide d'un procédé de dépôt thermique et avec une épaisseur de 0,2 à 5 µm, le produit intermédiaire comprenant ainsi la couche de zirconate-titanate de plomb.

4. Procédé selon la revendication 3, moyennant quoi, lors de la structuration de la couche de platine, la couche de zirconate-titanate de plomb est structurée simultanément par enlèvement de zones superflues de la couche de zirconate-titanate de plomb, ce qui permet de former, sur les électrodes de fond (8, 12), à l'aide des zones restantes de la couche de zirconate-titanate de plomb, les pixels de zirconate-titanate de plomb (9, 13) des pixels (7, 11) .

5. Procédé selon l'une des revendications 3 à 4, ce procédé comprenant l'étape suivante : fabrication d'une couche d'électrodes semi-transparente électro-conductrice directement sur la couche de zirconate-titanate de plomb avec un procédé de dépôt thermique, ce qui fait en sorte que le produit intermédiaire comprend la couche d'électrodes.

6. Procédé selon la revendication 5, la couche d'électrodes étant constituée de platine ou d'un alliage nickel-fer ou d'un alliage nickel-chrome.

7. Procédé selon la revendication 6, moyennant quoi, lors de la structuration en forme de pixels de la couche de platine et de la couche de zirconate-titanate de plomb, la couche d'électrodes est structurée simultanément par l'enlèvement de zones superflues de la deuxième couche de platine, ce qui permet de forme sur le pixel de zirconate-titanate de plomb (9, 13), à l'aide des zones restante de la deuxième couche de platine, les électrodes de tête (10, 14) des pixels (7, 11).

8. Procédé selon l'une des revendications 1 à 7, le procédé de dépôt thermique étant un procédé de pulvérisation.
